# EUROPEAN PATENT SPECIFICATION

(11) **EP 0 337 481 B1**
(45) Date of publication and mention of the grant of the patent: **07.09.1994**
(21) Application number: 89106711.8
(22) Date of filing: 14.04.1989
(51) Int. Cl.: H01L 29/60, H01L 29/54, H01L 29/40, H01L 29/62

(54) **Semiconductor device**
Halbleitervorrichtung
Dispositif semi-conducteur

(30) Priority: 15.04.1988 JP 93111/88
(43) Date of publication of application: 18.10.1989
(73) Proprietor: KABUSHIKI KAISHA TOSHIBA, Kawasaki-shi, Kanagawa-ken 210 (JP)
(72) Inventor: Kinugawa, Masaaki c/o Intellectual Property Div., Minato-ku Tokyo 105 (JP)
(74) Representative: Lehn, Werner, Dipl.-Ing.

(56) References cited:
- IBM TECHNICAL DISCLOSURE BULLETIN, vol. 27, no. 11, April 1985, pages 6652-6655, New York, US; "Three dual polysilicon gate CMOS with diffusion barriers and the process for forming each"

## Description

This invention relates to a semiconductor device having polysilicon layers doped with p- and n-type impurities, and more particularly to a semiconductor device having impurity doped polysilicon layers connected to each other.

With the development of the miniaturization technique of MOS transistors, the integration density of a semiconductor device has rapidly increased. Most of the miniaturized MOS transistors use polysilicon as electrode material. Moreover, the gate electrode of polysilicon is often doped with impurity of the same conductivity type as that of the source and drain regions to set the threshold voltage |VTH| of the MOS transistor into an optimum range or to suppress short channel effects. Further, polysilicon is often used as the source and drain electrodes to realize interconnection by polysilicon layer, where the source and drain electrodes of polysilicon are normally doped with impurity of the same conductivity type as that of the source and drain regions to reduce the contact resistance. In these cases, the polysilicon electrode has a sheet resistance relatively higher than the metal electrode. For this reason, it becomes a common practice to make the polysilicon layer thin and form a thick silicide layer such as TiSi₂ on the polysilicon layer in order to reduce the resistance of the electrode.

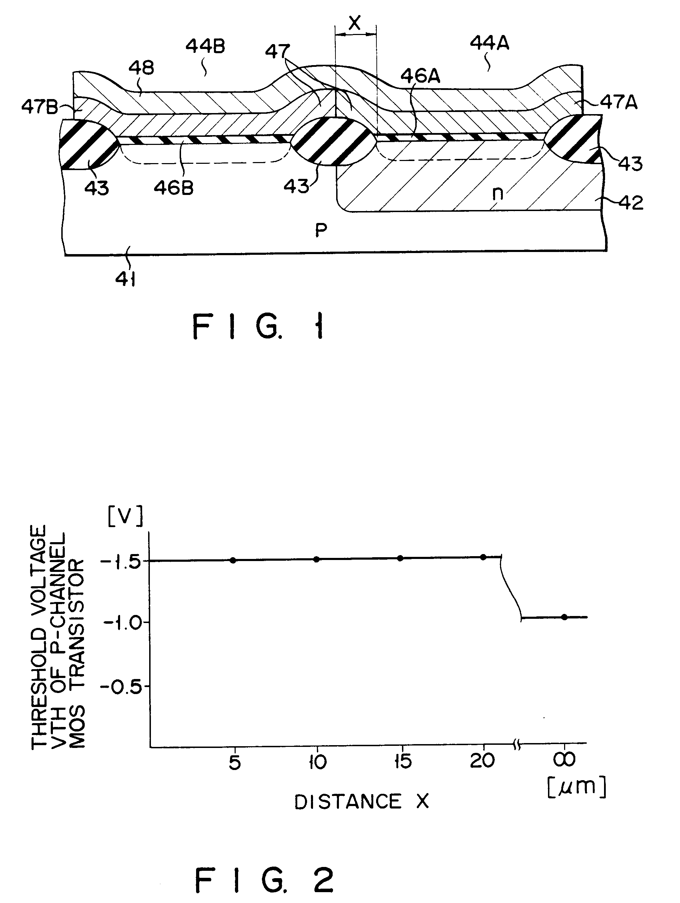

Fig. 1 shows the cross sectional structure of the conventional CMOS semiconductor device. In the semiconductor device, n-type well region 42 is formed in the surface area of p-type silicon substrate 41 and field insulating layer 43 is formed on silicon substrate 41 and well region 42. Further, p- and n-channel MOS transistors 44A and 44B are formed in the element formation regions defined by field insulating layer 43. The source and drain regions of MOS transistor 44A are formed of n-type regions (not shown) formed in the surface area of well region 42. The gate insulators of p- and n-channel MOS transistors 44A and 44B are formed of insulating films 46A and 46B respectively formed on well region 42 and silicon substrate 41. Further, impurity doped polysilicon layer 47 is formed on insulating films 46A and 46B and field insulating layer 43, and silicide layer 48 is formed on polysilicon layer 47. Part 47A of polysilicon layer 47 contains p-type impurity and serves as a gate electrode of p-channel MOS transistor 44A. Part 47B of polysilicon layer 47 contains n-type impurity and serves as a gate electrode of n-channel MOS transistor 44B. In Fig. 1, X indicates a distance from the connection node between gate electrodes 47A and 47B to the channel region lying between the source and drain regions of p-channel MOS transistor 44A.

The above semiconductor device has the following defect. That is, silicide has a large diffusion coefficient with respect to n-type impurity. For this reason, when the semiconductor device is subjected to the heat treatment in the manufacturing process after the formation of the polysilicon layer and silicide layer, n-type impurity moves from n-type polysilicon layer 47B to p-type polysilicon layer 47A via silicide layer 48, and is diffused in p-type polysilicon layer 47A. Since p-type polysilicon layer 47A is used as the gate electrode of MOS transistor 44A, the threshold voltage of the MOS transistor will be set to a value different from the designed value depending on variation in the impurity concentration of polysilicon layer 47A.

Fig. 2 is a diagram showing the relation between distance X and threshold voltage |VTH| of p-channel MOS transistor 44A shown in Fig. 1. If distance X is infinite, it is considered that there is no possibility that n-type impurity will be injected into p-type polysilicon layer 47A via silicide layer 48. When distance X takes a finite value, threshold voltage |VTH| of p-channel MOS transistor 44A will increase by 50% in comparison with that in a case where distance X is infinite.

Assuming that n-type impurity is injected into the source electrode (or drain electrode) of polysilicon, the contact resistance of the electrode and the source region (or drain region) will increase.

A CMOS structure having p- and n-type layers and a TiN diffusion layer is known from IBM Technical Disclosure Bulletin vol.27 no. 11 April 1985, p6652-6655. However the gate layers are separated from the finished device and the problems of a gate layer pn junction are not addressed.

An object of this invention is to provide a semiconductor device in which the resistance of a wiring for connecting p- and n-type polysilicon layers to each other can be reduced and n-type impurity contained in the n-type polysilicon layer can be prevented from being thermally diffused into the p-type polysilicon layer.

According to the present invention there is provided a semiconductor device comprising:
a semiconductor body ;
CMOS transistors having first and second polysilicon gate layers which are formed on said semiconductor body and contain p- and n-type impurities, respectively, said first and second polysilicon gate layers having edge surfaces formed in contact with each other; and
a refractory metal silicide layer formed on said first and second polysilicon gate layers ;
characterized in that
said semiconductor device further comprises a barrier layer of electrically conductive material, formed in the boundary between said refractory metal silicide layer and said first and second polysilicon gate layers to isolate said refractory metal silicide layer from said first and second polysilicon gate layers , and connected to said first and second polysilicon gate layers to shunt a pn junction between said first and second polysilicon gate layers ;
the diffusion coefficient of the n-type impurity is smaller in said barrier layer than in said refractory metal silicide layer ; and
said first and second polysilicon gate layers have top surfaces entirely covered with said conductive barrier layer.

With the above wiring construction, the diffusion coefficient of the n-type impurity is smaller in the conductive layer than in the silicide layer, and the conductive layer is formed between the silicide layer and the first and second polysilicon layers. Therefore, the n-type impurity contained in the first polysilicon silicon layer can be suppressed from being diffused into the silicide layer in a heat treatment process. Even if the n-type impurity has been diffused into the silicide layer, it can be further suppressed from being diffused into the first polysilicon layer. In a case where the second polysilicon layer is used as the gate electrode of a MOS transistor, for example, fluctuation in the threshold voltage of the MOS transistor can be suppressed. Further, in a case where the second polysilicon layer is used as the source electrode (or drain electrode) of a MOS transistor, increase in the contact resistance between the electrode and the source region (or drain region) can be prevented.

This invention can be more fully understood from the following detailed description when taken in conjunction with the accompanying drawings, in which:
Fig. 1 shows a sectional structure of the conventional CMOS semiconductor device;
Fig. 2 is a diagram showing variation in the threshold voltage of a p-channel MOS transistor shown in Fig. 1;
Fig. 3 shows a sectional structure of a CMOS semiconductor device according to one embodiment of this invention;
Fig. 4 is a diagram showing variation in the threshold voltage of a p-channel MOS transistor shown in Fig. 3;
Figs. 5A to 5H are diagrams showing a process of manufacturing a plurality of p- and n-channel MOS transistors having the same construction as the p- and n-channel MOS transistor shown in Fig. 3; and
Fig. 6 is a sectional view of a modification of the CMOS semiconductor device shown in Fig. 3. but is not part of the present invention.

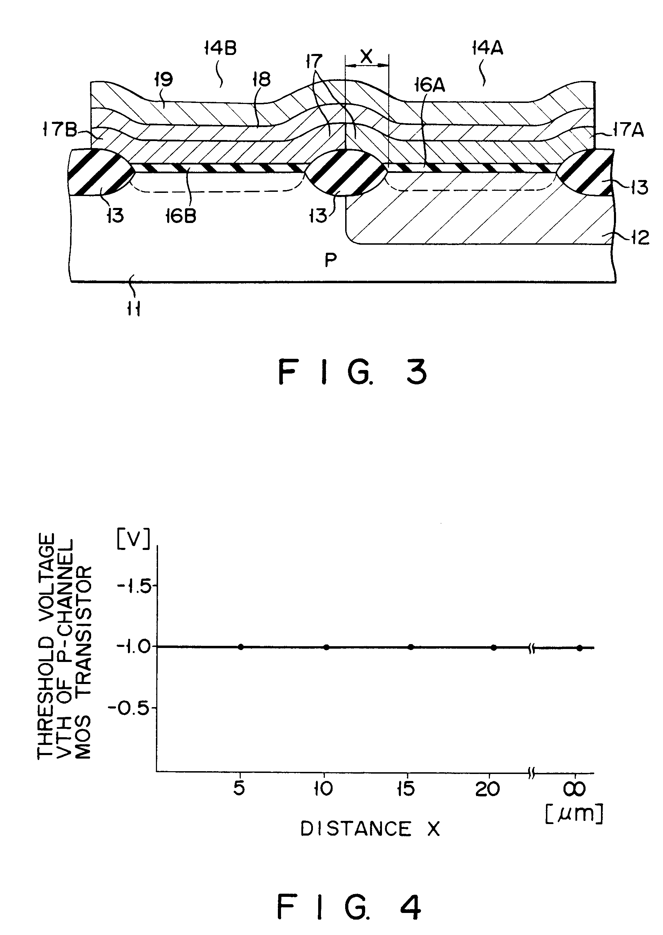

There will now be described a CMOS semiconductor device according to one embodiment of this invention with reference to Figs. 3 and 4. Fig. 3 shows the sectional structure of the CMOS semiconductor device. In the semiconductor device, n-type well region 12 is formed in the surface area of p-type silicon substrate 11, and field insulating layer 13 is formed on silicon substrate 11 and well region 12. Further, p- and n-channel MOS transistors 14A and 14B are formed in element formation regions defined by field insulating layer 13. The source and drain regions of MOS transistors 14A are constituted by p-type diffusion regions (not shown) formed in the surface area of well region 12. Further, the source and drain regions of MOS transistors 14B are constituted by n-type diffusion regions (not shown) formed in the surface area of silicon substrate 11. The gate insulators of p- and n-channel MOS transistors 14A and 14B are formed of insulating films 16A and 16B which are formed respectively on well region 12 and silicon substrate 11. Further, impurity doped polysilicon layer 17 is formed on insulating films 15A and 16B and field insulating layer 13, TiN layer 18 is formed to cover polysilicon layer 17, and silicide layer 19 is formed to cover TiN layer 18. Portion 17A of polysilicon layer 17 contains p-type impurity and serves as the gate electrode of p-channel MOS transistor 14A, and portion 17B of polysilicon layer 17 contains n-type impurity and serves as the gate electrode of n-channel MOS transistor 14B. In Fig. 3, X indicates a distance from the connection node between gate electrodes 17A and 17B to the channel region lying between the source and drain regions of p-channel MOS transistor 14A.

Fig. 4 is a diagram showing the relation between distance X and threshold voltage |VTH| of p-channel MOS transistor 14A shown in Fig. 3. Threshold voltage |VTH| of p-channel MOS transistor 14A is kept constant irrespective of distance X. In other words, n-type impurity contained in n-type polysilicon layer 17B cannot be thermally diffused into the p-type polysilicon layer owing to the formation of TiN layer 18.

Next, the process of manufacturing a plurality of p- and n-channel MOS transistors having the same construction as that shown in Fig. 3 is explained with reference to Figs. 5A to 5H.

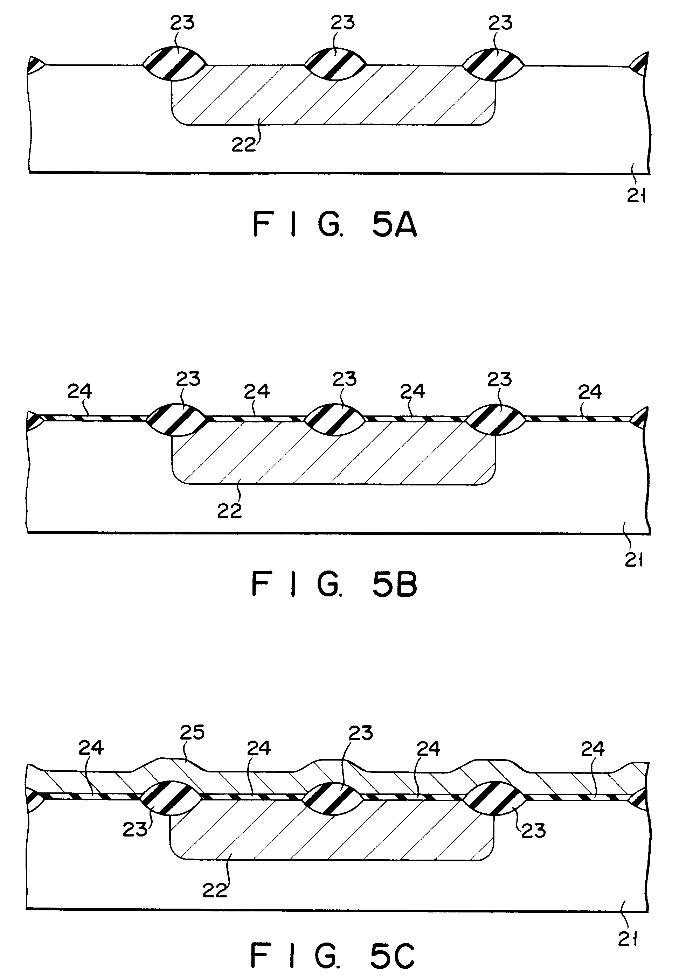

In a step shown in Fig. 5A, n-type well region 22 with an impurity concentration of 8 × 10¹⁶ cm³ is formed in p-type silicon substrate 21 with resistivity of 1 Ω·cm. Field insulating layer 23 is formed by forming an oxide film on silicon substrate 21, forming a nitride film on the oxide film, patterning the nitride film, and thermally oxidizing the exposed portion of the oxide film at temperatures of approx. 1000°C with the nitride film pattern used as a mask. After the masked portion of the oxide film and nitride film pattern are removed, ion-implantation process is effected to control the threshold voltages of the p- and n-channel MOS transistors. In this case, impurity ion for the p-channel MOS transistor is implanted into the exposed portion of well region 22, and impurity ion for the n-channel MOS transistor is implanted into the exposed portion of silicon substrate 21. The exposed portion of silicon substrate 21 is subjected to a heat treatment at approx. 900°C in an O₂ atmosphere in order to form gate oxide film 24 of 150 Å as shown in Fig. 5B.

After this, polysilicon layer 25 shown in Fig. 5C is formed by depositing polysilicon to a thickness of 2000 Å on the entire surface of gate oxide film 24 and field insulating layer 23 by the LPCVD method. Then, p-type polysilicon layer 25A shown in Fig. 5D is formed by forming resist film 26 to cover polysilicon layer 25 except the upper portion of well region 22 and ion-implanting BF₂⁺ ions into the exposed portion of polysilicon layer 25 with a dose amount of 1 × 10¹⁵ cm⁻² at an acceleration energy of 30 KeV. Next, n-type polysilicon layer 25B shown in Fig. 5E is formed by forming resist film 27 to cover polysilicon layer 25 after resist film 26 has been removed, and ion-implanting As⁺ ions into the exposed portion of polysilicon layer 25 with a dose amount of 1 × 10¹⁵ cm⁻² at an acceleration energy of 40 KeV. Then, resist film 27 is removed.

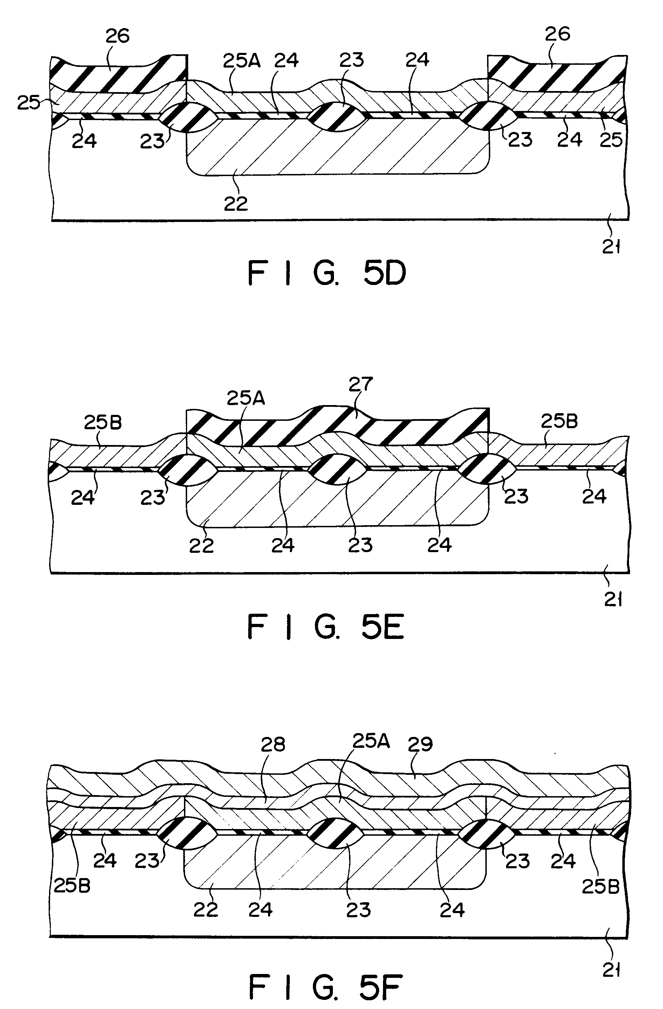

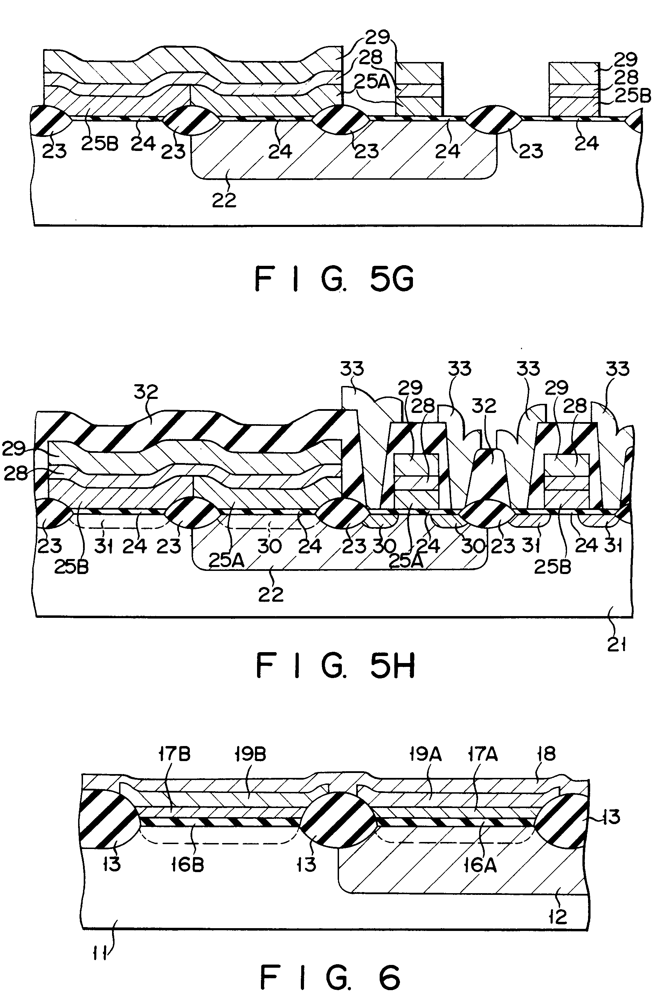

In the step of Fig. 5F, TiN layer 28 is formed to a thickness of approx. 1000 Å (10Å=1nm) on p- and n-type polysilicon layers 25A and 25B by the sputtering method, and then TiSi₂ layer 29 is formed to a thickness of 2000 Å on TiN layer 28. After this, as shown in Fig. 5G, TiSi₂ layer 29, TiN layer 28 and polysilicon layers 25A and 25B are sequentially subjected to the anisotropic etching process using a photoresist pattern formed by the lithographic process as a mask. After the three-layered gate electrodes are thus formed, an annealing process is effected at about 900°C in an N₂ atmosphere for 10 minutes.

In the step of Fig. 5H, BF₂⁺ ions are ion-implanted into well region 22 with a dose amount of 1 × 10¹⁵ cm⁻² at an acceleration energy of 20 KeV, As⁺ ions are ion-implanted into silicon substrate 21 with a dose amount of 1 × 10¹⁵ cm⁻² at an acceleration energy of 30 KeV, and then an annealing process is effected at about 900°C in an N₂ atmosphere for 10 minutes. As a result, source and drain regions 30 of the p-channel MOS transistors are formed in well 22, and source and drain regions 31 of the n-channel MOS transistors are formed in silicon substrate 21. After this, PSG film 32 is formed to a thickness of approx. 8000 Å as a protection film by the CVD method, Al wiring layer 33 is formed on PSG film 32 after contact holes have been formed in part of PSG film 32. Formation of the semiconductor device is completed by further forming desired semiconductor elements in the peripheral portions of the MOS transistors thus formed.

In the embodiment described above, the top surfaces of p- and n-type polysilicon layers 17A and 17B are entirely covered with TiN layer 18, and the top surface of TiN layer 18 is entirely covered with TiSi₂ layer 19. Since TiSi₂ layer 19 is formed to have a lower resistance than p- and n-type polysilicon layers 17A and 17B, the resistance of a wiring for connecting polysilicon layers 17A and 17B to each other can be reduced in comparison with the case where TiSi₂ layer 19 is not formed. Further, since the diffusion coefficient of n-type impurity in TiN layer 18 is smaller than in TiSi₂ layer 19, it becomes more difficult for n-type impurity in n-type polysilicon layer 17B to thermally diffuse into p-type polysilicon layer 17A in comparison with the case where TiN layer 18 is not formed. Therefore, it becomes possible to set the threshold voltage of p-channel MOS transistor 44A to a designed value irrespective of the manufacturing process.

In this embodiment, p-type polysilicon layer 17A is formed as the gate electrode of of MOS transistor 44A. However, p-type polysilicon layer 17A may be a contact electrode formed on the p-type diffusion region, for example. In this case, increase in the contact resistance between polysilicon layer 17A and the p-type diffusion region can be prevented.

TiN layer 18 may be replaced by a conductive layer which can provide a smaller diffusion coefficient with respect to n-type impurity than silicide layer 19.

Further, in this embodiment, polysilicon layers 17A and 17B are formed in contact with each other. However, if polysilicon layers 17A and 17B are not formed in contact with each other as shown in Fig. 6, TiSi₂ layers 19A and 19B are formed to cover polysilicon layers 17A and 17B and TiN layer 18 may be formed to cover TiSi₂ layers 19a and 19B so as to attain the same effect as in the above embodiment.

## Claims

1. A semiconductor device comprising:
a semiconductor body (11, 12);
CMOS transistors (14A, 14B) having first and second polysilicon gate layers (17A, 17B) which are formed on said semiconductor body (11, 12) and contain p- and n-type impurities, respectively, said first and second polysilicon gate layers having edge surfaces formed in contact with each other; and
a refractory metal silicide layer (19) formed on said first and second polysilicon gate layers (17A, 17B);
characterized in that
said semiconductor device further comprises a barrier layer (18) of electrically conductive material, formed in the boundary between said refractory metal silicide layer (19) and said first and second polysilicon gate layers (17A, 17B) to isolate said refractory metal silicide layer (19) from said first and second polysilicon gate layers (17A, 17B), and connected to said first and second polysilicon gate layers (17A, 17B) to shunt a pn junction between said first and second polysilicon gate layers (17A, 17B);
the diffusion coefficient of the n-type impurity is smaller in said barrier layer (18) than in said refractory metal silicide layer (19); and
said first and second polysilicon gate layers (17A, 17B) have top surfaces entirely covered with said conductive barrier layer (18).

2. A semiconductor device according to claim 1, characterized in that said semiconductor body (11, 12) includes and n-type substrate layer (12), in a surface of which source and drain regions of a p-channel MOS transistor (14A) are formed, and said first polysilicon layer (17A) serves as a gate electrode of said p-channel MOS transistor (14A), the gate electrode of the p-channel MOS transistor (14A) being formed over and insulated from that portion of said n-type substrate layer (12) which lies between said source and drain regions.

3. A semiconductor device according to claim 2, characterized in that said semiconductor body includes a p-type substrate layer (11), in a surface of which source and drain regions of an n-channel MOS transistor (14B) are formed, and said second polysilicon layer (17B) serves as a gate electrode of said n-channel MOS transistor (14B), the gate electrode of said n-channel MOS transistor being formed in that portion of the p-type substrate layer (11) which lies between said source and drain regions of said n-channel MOS transistor (14B).

4. A semiconductor device according to claim 1, characterized in that said semiconductor body (11, 12) includes a p-type element region, and said second polysilicon layer (17A) serves as a contact electrode of said p-type element region.

5. A semiconductor device according to claim 1, characterized in that said refractory metal silicide layer (19) is formed of TiSi₂, and said barrier layer (18) is formed of TiN.

## Patentansprüche

1. Halbleitereinrichtung, aufweisend:
- einen Halbleiterkörper (11, 12);
- CMOS-Transistoren (14A, 14B) mit einer ersten und zweiten Polysilicium-Gatterschicht (17A, 17B), die auf dem Halbleiterkörper (11, 12) gebildet sind und jeweils entsprechend p- und n-leitende Störstellen enthalten, wobei die erste und die zweite Polysilicium-Gatterschicht Kantenoberflächen aufweisen, die in Kontakt mit einander gebildet sind; und
- eine feuerfeste Metallsilicidschicht (19), die auf der ersten und der zweiten Polysilicium-Gatterschicht (17A, 17B) gebildet ist;
dadurch **gekennzeichnet**, daß
- die Halbleitereinrichtung weiter eine Sperrschicht (18) aus elektrisch leitendem Material aufweist, die in der Grenze zwischen der feuerfesten Metallsilicidschicht (19) und der ersten und zweiten Polysilicium-Gatterschicht (17A, 17B) gebildet ist, um die feuerfeste Metallsilicidschicht (19) von der ersten und zweiten Polysilicium-Gatterschicht (17A, 17B) zu trennen, und die an die erste und zweite Polysilicium-Gatterschicht (17A, 17B) angeschlossen ist, um einen pn-Üergang zwischen der ersten und der zweiten Polysilicium-Gatterschicht (17A, 17B) zu shunten;
- der Diffusionskoeffizient der n-leitenden Störstelle in der Sperrschicht (18) kleiner als in der feuerfesten Metallsilicidschicht (19) ist; und
- die erste und zweite Polysilicium-Gatterschicht (17A, 17B) obere Oberflächen besitzen, die ganz mit der leitenden Sperrschicht (18) bedeckt sind.

2. Halbleitereinrichtung nach Anspruch 1,
dadurch **gekennzeichnet**, daß der Halbleiterkörper (11, 12) eine n-leitende Substratschicht (12) umfaßt, wobei in einer Oberfläche derselben Source- und Drainbereiche eines MOS-Transistors (14A) mit p-Kanal gebildet sind, und daß die erste Polysiliciumschicht (17A) als Gatterelektrode des MOS-Transistors (14A) mit p-Kanal dient, wobei die Gatterelektrode des MOS-Transistors (14A) mit p-Kanal über demjenigen Abschnitt der n-leitenden Substratschicht (12) gebildet ist bzw. gegen diesen isoliert ist, der zwischen dem Source- und dem Drainbereich liegt.

3. Halbleitereinrichtung nach Anspruch 2,
dadurch **gekennzeichnet**, daß der Halbleiterkörper eine p-leitende Substratschicht (11) aufweist, wobei in einer Oberfläche derselben Source- und Drainbereiche eines MOS-Transistors (14B) mit n-Kanal gebildet sind, und daß die zweite Polysiliciumschicht (17B) als Gatterelektrode des MOS-Transistors (14B) mit n-Kanal dient, wobei die Gatterelektrode des MOS-Transistors mit n-Kanal in demjenigen Abschnitt der p-leitenden Substratschicht (11) gebildet ist, die zwischen dem Source- und Drainbereich des MOS-Transistors (14B) mit n-Kanal liegt.

4. Halbleitereinrichtung nach Anspruch 1,
dadurch **gekennzeichnet**, daß der Halbleiterkörper (11, 12) einen p-leitenden Elementenbereich aufweist, und daß die zweite Polysiliciumschicht (17A) als Kontaktelektrode des p-leitenden Elementenbereiches dient.

5. Halbleitereinrichtung nach Anspruch 1,
dadurch **gekennzeichnet**, daß die feuerfeste Metallsilicidschicht (19) aus TiSi₂ gebildet ist, und daß die Sperrschicht (18) aus TiN gebildet ist.

## Revendications

1. Dispositif à semiconducteur comprenant :
un corps semiconducteur (11, 12) ;
des transistors métal-oxyde-semiconducteur complémentaires CMOS (14A, 14B) comportant des première et seconde couches de grille en silicium polycristallin ou polysilicium (17A, 17B) qui sont formées sur ledit corps semiconducteur (11, 12) et qui contiennent respectivement des impuretés de type P et de type N, lesdites première et seconde couches de grille en polysilicium comportant des surfaces de bord formées de manière à être en contact les unes avec les autres ; et
une couche en siliciure de métal réfractaire (19) formée sur lesdites première et seconde couches de grille en polysilicium (17A, 17B),
caractérisé en ce que :
ledit dispositif à semiconducteur comprend en outre une couche barrière (18) en un matériau électriquement conducteur, formée dans la frontière entre ladite couche en siliciure de métal réfractaire (19) et lesdites première et seconde couches de grille en polysilicium (17A, 17B), pour isoler ladite couche en siliciure de métal réfractaire (19) desdites première et seconde couches de grille en polysilicium (17A, 17B), et connectée auxdites première et seconde couches de grille en polysilicium (17A, 17B) pour shunter une jonction PN entre lesdites première et seconde couches de grille en polysilicium (17A, 17B) ;
le coefficient de diffusion de l'impureté de type N est plus faible dans ladite couche barrière (18) que dans ladite couche en siliciure de métal réfractaire (19) ; et
lesdites première et seconde couches de grille en polysilicium (17A, 17B) comportent des surfaces supérieures entièrement recouvertes par ladite couche barrière conductrice (18).

2. Dispositif à semiconducteur selon la revendication 1, caractérisé en ce que ledit corps semiconducteur (11, 12) inclut une couche de substrat de type N (12) et dans une surface de celle-ci, des régions de source et de drain d'un transistor métal-oxyde-semiconducteur MOS à canal P (14A) sont formées et ladite première couche en polysilicium (17A) sert d'électrode de grille dudit transistor MOS à canal P (14A), l'électrode de grille du transistor MOS à canal P (14A) étant formée sur la partie de ladite couche de substrat de type N (12) qui s'étend entre lesdites régions de source et de drain et étant isolée de celle-ci.

3. Dispositif à semiconducteur selon la revendication 2, caractérisé en ce que ledit corps semiconducteur inclut une couche de substrat de type P (11) et dans une surface de celle-ci, des régions de source et de drain d'un transistor MOS à canal N (14B) sont formées et ladite seconde couche de polysilicium (17B) sert d'électrode de grille dudit transistor MOS à canal N (14B), l'électrode de grille dudit transistor MOS à canal N étant formée dans la partie de la couche de substrat de type P (11) qui s'étend entre lesdites régions de source et de drain dudit transistor MOS à canal N (14B).

4. Dispositif à semiconducteur selon la revendication 1, caractérisé en ce que ledit corps semiconducteur (11, 12) inclut une région de type P et ladite seconde couche en polysilicium (17A) sert d'électrode de contact de ladite région d'élément de type P.

5. Dispositif à semiconducteur selon la revendication 1, caractérisé en ce que ladite couche en siliciure de métal réfractaire (19) est constituée par du TiSi₂ et ladite couche barrière (18) est constituée par du TiN.
